# EUROPEAN PATENT SPECIFICATION

(11) **EP 4 025 019 B1**
(45) Date of publication and mention of the grant of the patent: **10.04.2024**
(21) Application number: 20861917.1
(22) Date of filing: 02.09.2020
(51) Int. Cl.: H05K 3/36, H05K 1/14, H05K 1/02

(54) **ELECTRONIC DEVICE**
ELEKTRONISCHE VORRICHTUNG
DISPOSITIF ÉLECTRONIQUE

(30) Priority: 05.09.2019 CN 201910838308
(43) Date of publication of application: 06.07.2022
(73) Proprietor: Honor Device Co., Ltd., Shenzhen, Guangdong 518040 (CN)
(72) Inventor: JIANG, Fan, Shenzhen, Guangdong 518040 (CN); LIU, Peng, Shenzhen, Guangdong 518040 (CN); ZHANG, Tong, Shenzhen, Guangdong 518040 (CN); CHE, Jihai, Shenzhen, Guangdong 518040 (CN); LI, Wenjing, Shenzhen, Guangdong 518040 (CN)
(74) Representative: Epping - Hermann - Fischer
(86) International application number: PCT/CN2020/112999
(87) International publication number: WO 2021/043161

(56) References cited:
- EP-A1- 0 026 839
- EP-A1- 2 389 050
- CN-A- 101 273 494
- CN-A- 105 632 382
- CN-U- 209 250 938
- JP-A- H0 212 890
- JP-A- H05 283 557
- US-A1- 2002 088 986
- US-B1- 6 208 022
- US-B1- 6 490 168

## Description

### TECHNICAL FIELD

The present invention relates to the technical field of electronic devices, and in particular, to a circuit board and an electronic device.

### BACKGROUND

An electronic device is generally provided with a printed circuit board. The printed circuit board is configured to carry electronic components. The printed circuit board is provided with circuits connected to electronic components. The printed circuit board is usually connected to a device such as a display or another printed circuit board by using a flexible circuit board. Specifically, a plurality of first pins are disposed on a surface of the printed circuit board, and the first pins are all connected to a circuit on the printed circuit board; a plurality of second pins are disposed on the flexible circuit board, and the second pins are all connected to a circuit on the flexible circuit board. Each first pin is corresponding to one second pin and the first pin is soldered to the corresponding second pin, to implement connection between the flexible circuit board and the printed circuit board.

To implement positioning between the flexible circuit board and the printed circuit board, so that the first pin is opposite to the second pin to further facilitate soldering, usually, a first positioning hole is provided in the printed circuit board and a second positioning hole is provided in the flexible circuit board. During mounting, a positioning plate with a positioning rod is placed at a lower portion of the printed circuit board, the positioning rod is penetrated into the first positioning hole, then the flexible circuit board is covered on the printed circuit board, and the positioning rod is penetrated into the second positioning hole, to implement the positioning between the printed circuit board and the flexible circuit board by using the positioning rod, so that the first pin is opposite to the second pin.

However, the printed circuit board is generally a multi-layer circuit board, and after a first positioning hole is provided in a printed circuit, a circuit cannot be disposed inside the printed circuit board corresponding to the first positioning hole, which leads to a small use area of the printed circuit board EP2389050 A1 and US6208022 B1 disclose an electronic device wherein a flexible board is electrically connected to a circuit board by soldering.

### SUMMARY

In view of this, embodiments of the present invention provide an electronic device according to claim 1, so as to resolve the technical problem of the small use area of the circuit board caused by the fact that after a hole is provided in the circuit board, a circuit cannot be disposed inside the circuit board corresponding to the hole.

An embodiment of the present invention provides electronic device according to claim 1, including: a board body and a positioning block disposed on the board body, where the positioning block is inserted into a positioning hole in a flexible board. The board body is provided with the positioning block, and when the flexible board is mounted on the circuit board, the positioning block is inserted into the positioning hole, to further implement positioning between the flexible board and the circuit board, so that a first pin on the circuit board is opposite to a second pin on the flexible board, so as to facilitate soldering between the first pin and the second pin. Compared with a manner of positioning the circuit board and the flexible board by providing a first positioning hole in the circuit board and a second positioning hole in the flexible board, placing a positioning plate with a positioning rod at a lower portion of the circuit board, and penetrating the positioning rod into the first positioning hole and the second positioning hole, opening of a hole in the circuit board can be avoided, and a circuit can be provided inside the circuit board corresponding to the positioning block, which does not affect the use area of the circuit board.

In the foregoing circuit board, the positioning block is a metal block mainly made of a metal such as copper or aluminum. The material of the metal block can be easily obtained, and the metal block is simple to manufacture.

In the foregoing circuit board, the positioning block is electrically connected to a circuit on the board body. The positioning block is used as an external interface, so that the circuit board can be tested and debugged by using the positioning block, and there is no need to dispose an extra external interface on the circuit board for testing and debugging, thereby simplifying the structure of the circuit board.

In the foregoing circuit board, a soldering pad is provided on a surface of the board body, and a positioning block is soldered to the soldering pad. Such arrangement facilitates mounting of the positioning block.

In the foregoing circuit board, the soldering pad is electrically connected to the circuit on the board body. Electrical connection between the circuit on the circuit board and the positioning block is implemented by using the soldering pad, so that the circuit board can be tested or debugged by using the positioning block.

In the foregoing circuit board, there are a plurality of the positioning blocks, and the plurality of the positioning blocks are arranged at intervals. Correspondingly, a plurality of the positioning holes are provided in the flexible board, each positioning block is penetrated into one positioning hole, and the plurality of the positioning blocks can improve the accuracy of positioning between the circuit board and the flexible board.

In the foregoing circuit board, a first pin is disposed on the board body, the first pin is configured to be electrically connected to a second pin on the flexible board, and the plurality of the positioning blocks are distributed on a circumferential side of the first pin. The positioning block and the positioning hole are mainly configured to position the flexible board near the second pin, so that the second pin is opposite to the first pin, and the positioning is relatively accurate.

In the foregoing circuit board, there are a plurality of the first pins, the plurality of the first pins are arranged at intervals in a preset direction, and the plurality of the positioning blocks are distributed at two ends of the first pins in the preset direction. The flexible board is positioned from two ends of the preset direction.

In the foregoing circuit board, the positioning block is column shaped, and a bottom end of the positioning block is connected to the board body. The column-shaped positioning block has a simple structure and is convenient for processing and manufacturing.

### BRIEF DESCRIPTION OF DRAWINGS

FIG. 1 is a schematic diagram of a connection between a circuit board and a flexible board according to an embodiment of the present invention;
FIG. 2 is a top view 1 of a circuit board and a flexible board according to an embodiment of the present invention; and
FIG. 3 is a top view 2 of a circuit board and a flexible board according to an illustrative example.

### Description of reference numerals:

10: Circuit board;
101: First pin;
20: Flexible board;
201: Positioning hole;
202: Second pin; and
30: Positioning block.

### DESCRIPTION OF EMBODIMENTS

To make the objectives, technical solutions, and advantages of the embodiments of the present invention clearer, the following clearly and completely describes the technical solutions in the embodiments of the present invention with reference to the accompanying drawings in the embodiments of the present invention. Apparently, the described embodiments are only some but not all of the embodiments of the present invention.

### Embodiment 1

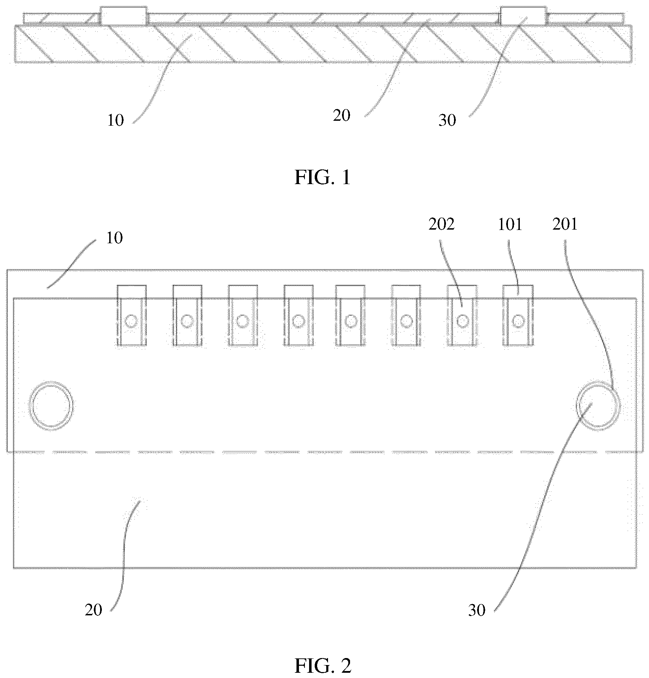

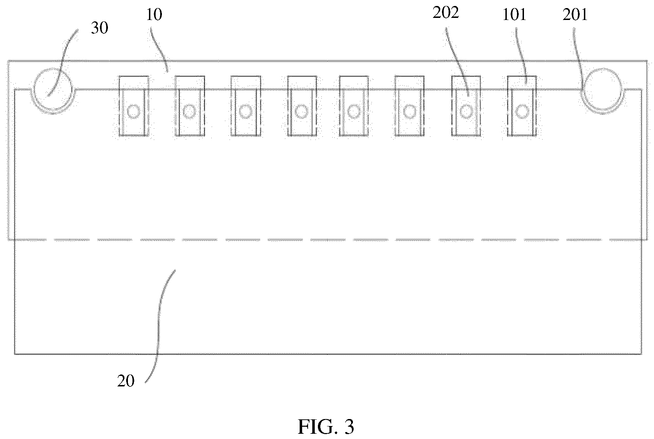

FIG. 1 is a schematic diagram of a connection between a circuit board and a flexible board according to an embodiment of the present invention; FIG. 2 is a top view 1 of a circuit board and a flexible board according to an embodiment of the present invention; and FIG. 3 is a top view 2 of a circuit board and a flexible board according to an illustrative example.

Referring to FIG. 1 and Fig. 2, a , this embodiment provides a circuit board 10, including: a board body and a positioning block 30 disposed on the board body, where the positioning block 30 is configured to be inserted into a positioning hole 201 in a flexible board 20.

Specifically, the circuit board 10 may be a single-layer board; and certainly, the circuit board 10 may alternatively be a multi-layer board, such as a 4-layer board or an 8-layer board. In addition, the circuit board 10 may be a hard board such as a printed circuit board, or may be a flexible circuit board having a specific flexibility.

In this embodiment, the board body includes at least one first substrate and a circuit that is made of a conductive material and disposed on the first substrate. The conductive material may be mainly made of a metallic material such as copper and aluminum; and certainly, the conductive material may alternatively be mainly made of a non-metallic conductive material such as graphite. For example, when the circuit board 10 is a single-layer board, the board body is provided with a first substrate, and a side surface of the first substrate is formed with a circuit having a specific pattern, where one side surface of the first substrate is formed with the circuit or two side surfaces of the first substrate are each formed with the circuit; or when the circuit board 10 is a multi-layer board, correspondingly, the board body includes a plurality of the first substrates, the plurality of the first substrates are stacked, and a side surface of each first substrate is provided with a circuit having a specific pattern.

It should be noted that the circuit having the specific pattern on the first substrate may be formed through etching. For example, a metal layer may be first formed on the first substrate through electroplating, a protective layer is subsequently formed on the metal layer, and then a mask is covered on the protective layer, where the mask is provided with a light shading part having the same shape as the pattern of the circuit; and subsequently, the mask is exposed, and in the exposing process, the protective layer outside the light shading part undergoes a physical or chemical change due to illumination, and subsequently the exposed protective layer and the metal layer corresponding to the exposed protective layer are etched by using an etching solution, to further form a circuit having the same pattern as the circuit.

Further, when the circuit board 10 is a multi-layer circuit board 10, to implement the connection between circuits on different side surfaces of a same first substrate or between circuits on different first substrates, a via hole may be provided in the first substrate, and the circuits are connected by using the via hole.

Specifically, the first substrate is an insulation plate. For example, when the circuit board 10 is a printed circuit board, the first substrate may be mainly made of epoxy resin phenolic cotton paper or the like; or when the circuit board 10 has a specific flexibility, the first substrate may be made of an insulation material having a good bending property such as a polyimide or polyester film. Further, when the circuit board 10 is a printed circuit board, a reinforcing material such as a glass fiber may be provided inside the first substrate to improve strength of the first substrate.

Specifically, electronic components such as capacitors and resistors may be disposed on the board body, and the electronic components are electrically connected to the circuit on the board body, so that the electronic components operate when the circuit is charged.

In this embodiment, the circuit board 10 is connected to another circuit board or an electrical device such as a display by using the flexible board 20, and the flexible board 20 has a good bending property and does not break after being bent, so as to adapt to the position difference between the circuit board 10 and the electrical device.

Specifically, the flexible board 20 is a flexible circuit board. The flexible board 20 includes a second substrate and a circuit having a specific pattern and disposed on the second substrate. After the flexible board 20 is connected to the circuit board 10, a circuit on the flexible circuit board is electrically connected to a circuit on the circuit board 10. The flexible board 20 may be premounted on another circuit board or an electrical device such as a display, and then the flexible board 20 may be connected to the circuit board 10. Certainly, one end of the flexible board 20 may be connected to the circuit board 10 first, and then the other end of the flexible board 20 may be connected to another circuit board or an electrical device such as a display.

The second substrate may be mainly made of an insulation material having a good bending property such as a polyimide or polyester film, and a circuit made of a conductive material may be formed on the second substrate through etching. For example, the conductive material may be mainly made of a metallic material such as copper or aluminum; and certainly, the conductive material may alternatively be mainly made of a non-metallic conductive material such as graphite. Specifically, a flexible substrate may be a single-layer board or may be a multi-layer board. When the flexible board 20 is a single-layer board, the flexible board 20 is provided with a second substrate, where one side surface of the second substrate may be formed with a circuit having a specific pattern or two side surfaces of the second substrate may each be formed with a circuit having a specific pattern; or when the flexible board 20 is a multi-layer board, correspondingly, the flexible board 20 includes a plurality of the second substrates, the plurality of the second substrates are stacked, and a side surface of each second substrate is provided with a circuit having a specific pattern.

Continuously referring to FIG. 2, in this embodiment, the circuit on the circuit board 10 is connected to the circuit on the flexible board 20. Specifically, the circuit board 10 may be provided with a first pin 101, there may be a plurality of the first pins 101, and the first pins 101 are electrically connected to the circuit on the circuit board 10. Correspondingly, the flexible board 20 is provided with a second pin 202, there may also be a plurality of the second pins 202, and the second pins 202 are electrically connected to the circuit on the flexible board 20. During mounting, the flexible board 20 is attached to the circuit board 10, one first pin 101 is corresponding to one second pin 202, and the first pin 101 and the second pin 202 are soldered together, to implement the connection between the circuit board 10 and the flexible board 20.

For example, the first pin 101 and the second pin 202 may be both made of a metallic material such as copper or aluminum; and certainly, the first pin 101 and the second pin 202 may alternatively be made of a non-metallic conductive material such as graphite.

Continuously referring to FIG. 1 to FIG. 2, in this embodiment, the positioning block 30 is disposed on the board body of the circuit board 10, and correspondingly, the positioning hole 201 is provided in the corresponding flexible board 20. The positioning block 30 is clamped in the positioning hole 201 to implement the positioning between the circuit board 10 and the flexible board 20, so that the first pin 101 on the circuit board 10 is opposite to the second pin 202 on the flexible board 20.

The positioning block 30 is connected to the board body by soldering.

The positioning block 30 is made of a metallic material such as copper or aluminum.

The positioning block 30 has a cylindrical shape. The positioning block 30 may be column shaped, and a bottom end of the positioning block 30 is connected to the board body. Such arrangement results in a simple structure and facilitates processing and manufacturing.

The positioning hole 201 provided in the flexible board 20 has a circular shape, such that the positioning block 30 can be penetrated into the positioning hole 201, so as to implement the positioning between the circuit board 10 and the flexible board 20. It should be noted that by reducing the distance between the positioning block 30 and the positioning hole 201 as much as possible, a relatively high accuracy of positioning between the circuit board 10 and the flexible board 20 can be ensured. The distance between the positioning block 30 and the positioning hole 201 is 0.05 mm to 0.1 mm when the positioning block 30 is penetrated into the positioning hole 201.

Specifically, continuously referring to FIG. 2, the positioning hole 201 is a complete hole, that is, the positioning block 30 can only be inserted into the positioning hole 201 in a direction perpendicular to the flexible board 20. Referring to FIG. 3, the positioning hole 201 is a half hole formed inward at a side edge of the flexible board 20, and the positioning block 30 is clamped in the positioning hole 201 in a direction parallel to the flexible board 20 in addition to being inserted into the positioning hole 201 in the direction perpendicular to the flexible board 20. In this case, the positioning block 30 is only partially accommodated in the positioning hole 201.

The process of mounting the circuit board 10 and the flexible board 20 provided in this embodiment is as follows: The flexible board 20 is covered on the circuit board 10, and the surface of the flexible board 20 having the second pin 202 is enabled to face the surface of the circuit board 10 having the first pin 101. In the foregoing process, the positioning hole 201 in the flexible board 20 is sleeved on the positioning block 30, and the positioning block 30 is matched with the positioning hole 201 to limit the position between the flexible board 20 and the circuit board 10, so that the first pin 101 on the circuit board 10 is opposite to the second pin 202 on the flexible board 20; and subsequently the first pin 101 and the second pin 202 are soldered together, to implement the connection between the circuit board 10 and the flexible board 20.

In the circuit board 10 provided in this embodiment, the board body is provided with a positioning block 30, and when the flexible board 20 is mounted on the circuit board 10, the positioning block 30 is inserted into the positioning hole 201, to further implement positioning between the flexible board 20 and the circuit board 10, so that a first pin 101 on the circuit board 10 is opposite to a second pin 202 on the flexible board 20, so as to facilitate soldering between the first pin 101 and the second pin 202. Compared with a manner of positioning the circuit board and the flexible board by providing a first positioning hole in the circuit board and a second positioning hole in the flexible board, placing a positioning plate with a positioning rod at a lower portion of the circuit board, and penetrating the positioning rod into the first positioning hole and the second positioning hole, opening of a hole in the circuit board 10 can be avoided, and a circuit can be provided inside the circuit board 10 corresponding to the positioning block 30, which does not affect the use area of the circuit board 10. Therefore, the circuit board 10 can be designed to be small, thereby reducing the production cost of the circuit board 10.

In addition, compared with a manner of positioning the circuit board and the flexible board by providing the first positioning hole in the circuit board and the second positioning hole in the flexible board, placing the positioning plate with the positioning rod at the lower portion of the circuit board, and penetrating the positioning rod by using the first positioning hole and the second positioning hole, there is a specific gap between the positioning rod and the first positioning hole and the second positioning hole, so that a movement margin between the first positioning hole and the second positioning hole is relatively large, in the circuit board 10 provided in this embodiment, the positioning block 30 is disposed on the board body, and a gap is provided only between the positioning block 30 and the positioning hole 201, so that the movement margin between the circuit board 10 and the flexible board 20 is relatively small, thereby improving the accuracy of positioning between the circuit board 10 and the flexible board 20.

In this embodiment, the positioning block 30 is a metal block. The metal block is made of a metallic material such as copper or aluminum. The material can be easily obtained, and the metal block is simple to manufacture.

Specifically, the positioning block 30 is electrically connected to a circuit on the circuit board 10. With such arrangement, the positioning block 30 may be used as an external interface, so that the circuit board 10 can be tested and debugged by using the positioning block 30, and there is no need to dispose an extra external interface on the circuit board 10 for testing and debugging, thereby simplifying the structure of the circuit board 10. Certainly, the positioning block 30 may alternatively serve as an interface for an electrical element. The electrical element is connected to the circuit on the circuit board 10 by using the positioning block 30.

Further, the positioning block 30 is electrically connected to a circuit on the surface where the positioning block 30 is located. When the circuit board 10 is a multi-layer circuit board 10, the positioning block 30 may be connected to a circuit inside the board body, and correspondingly, a hole may be provided in the board body, a lower end of the hole extends to an interior of the board body, and a lower end of the positioning block 30 is inserted into the hole and connected to the circuit inside the board body.

In this embodiment, a soldering pad is provided on a surface of the board body, and the positioning block 30 is soldered to the soldering pad. Such arrangement facilitates mounting of the positioning block 30.

In this embodiment, the soldering pad may be a metal sheet provided on the surface of the board body. Specifically, the soldering pad may be formed while a circuit is formed on the surface of the board body through etching or the like, to simplify a machining process of the circuit board 10. Certainly, in this embodiment, the soldering pad may alternatively be attached to the board body after the circuit is formed on the board body.

For example, the positioning block 30 may be connected to the soldering pad through laser soldering. Specifically, a solder may be formed on the soldering pad in advance, the positioning block 30 is bonded to the soldering pad, and then the solder is irradiated by laser to melt the solder by heat, thereby implementing soldering between the positioning block 30 and the soldering pad. Certainly, the positioning block 30 may alternatively be connected to the soldering pad through surface mounting. Specifically, a solder may be formed on the soldering pad in advance, and then the positioning block 30 is attached to the soldering pad by using a chip mounter. When the positioning block 30 is attached to the soldering pad, the mounter heats the solder to melt the solder, thereby implementing soldering between the positioning block 30 and the soldering pad. It should be noted that the solder may be mainly made of a metallic material such as tin, lead, or a tin-lead alloy. In this embodiment, the manner of soldering the positioning block 30 and the soldering pad is not limited to the foregoing two manners, provided that the positioning block 30 can be soldered to the soldering pad.

Specifically, when the positioning block 30 is soldered to the soldering pad, the soldering pad may be connected to the circuit on the board body to implement the connection between the circuit on the circuit board 10 and the positioning block 30, and then the circuit board 10 can be tested or debugged by using the positioning block 30.

Continuously referring to FIG. 2, in this embodiment, there are a plurality of the positioning blocks 30, and the plurality of the positioning blocks 30 are arranged at intervals. Correspondingly, a plurality of positioning holes 201 are provided in the flexible board 20. When the flexible board 20 is mounted on the circuit board 10, one positioning block 30 is penetrated into one positioning hole 201, and the plurality of the positioning blocks 30 are all configured to position the circuit board 10 and the flexible board 20, so that the accuracy of positioning between the circuit board 10 and the flexible board 20 can be improved. In addition, rotation of the flexible board 20 with respect to the circuit board 10 can be avoided as compared to the case in which one positioning block 30 is provided.

For example, the quantity of positioning blocks 30 may be two, three, four, or the like, and this is not limited in this embodiment. It should be noted that when there are a plurality of the positioning blocks 30, the plurality of the positioning blocks 30 may all be connected to the circuit of the circuit board 10, or only some of the positioning blocks 30 are connected to the circuit of the circuit board 10, and the remaining positioning blocks 30 are not connected to the circuit of the circuit board 10. This is not limited in this embodiment.

Specifically, when there are a plurality of the positioning blocks 30, the plurality of the positioning blocks 30 may be distributed on a circumferential side of the first pin 101. With such arrangement, the positioning blocks 30 and the positioning holes 201 are mainly configured to position the flexible board 20 near the second pin 202, so that the second pin 202 is opposite to the first pin 101, and the positioning is relatively accurate. For example, the plurality of the positioning blocks 30 may be disposed around the first pin 101, and correspondingly, the positioning holes 201 provided in the flexible board 20 are disposed around the second pin 202.

Further, there are a plurality of the first pins 101, the plurality of the first pins 101 are arranged at intervals in a preset direction, and the plurality of the positioning blocks 30 are distributed at two ends of the first pins 101 in the preset direction. Specifically, the plurality of the first pins 101 are arranged at intervals in the preset direction, and correspondingly, the positioning blocks 30 are provided at two ends of the plurality of first pins 101 in the preset direction.

Continuously referring to FIG. 2, in this embodiment, there are preferably two positioning blocks 30, where one of the positioning blocks 30 is disposed at one end of the plurality of the first pins 101 in the preset direction, and the other positioning block 30 is provided at the other end of the plurality of the first pins 101 in the preset direction.

In the description of the present invention, it should be understood that the orientations or positional relationships indicated by terms such as "center", " longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", and the like are based on the orientations or positional relationships illustrated in the accompanying drawings and merely intended for convenience of describing the present invention and simplifying the description, rather than indicating or implying that the apparatus or element indicated need to have a particular orientation, be constructed and operate in a particular orientation, and therefore cannot be construed as a limit to the present invention.

In the present invention, unless otherwise expressly specified, terms such as "mount", "joint", "connect", "secure", and the like should be understood in a broad sense, and may be, for example, a fixed connection, a detachable connection, or integrally formed, a mechanical connection, or may be an electrical connection, or communicable with one another; or may be direct connection or indirect connection by using an intermediate medium, or may be an internal communication between two elements or an interaction between two elements, unless otherwise expressly defined. The specific meanings of the foregoing terms in the present invention can be understood by persons of ordinary skill in the art according to specific situations.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all of the technical features thereof, without departing from the scope of the appended claims.

## Claims

1. An electronic device, comprising a flexible board (20) and a circuit board (10), wherein the flexible board (20) is provided with a positioning hole (201) and a second pin (202) electrically connected to a circuit on the flexible board (20), the circuit board (10) comprising a board body and a positioning block (30) disposed on the board body,
wherein the positioning block is a metal block; the positioning block is electrically connected to a circuit on the board body; wherein a soldering pad is disposed on a surface of the board body, and the positioning block is soldered to the soldering pad, wherein there are a plurality of the positioning blocks, and the plurality of the positioning blocks are arranged at intervals, wherein a first pin (101) is disposed on the board body, the first pin is electrically connected to the circuit on the board body, and the first pin is configured to be electrically connected to a second pin (202) on the flexible board to connect the circuit on the circuit board (10) to the circuit on the flexible board (20), and the plurality of the positioning blocks are distributed on a circumferential side of the first pin; and
the positioning hole (201) is a circular hole, the positioning block (30) is cylindrical, wherein the positioning block (30) is penetrated into the positioning hole (201) and the distance between the positioning block (30) and the positioning hole (201) is 0.05 mm to 0.1 mm and the positioning block (30) forms an external interface, so that the circuit board (10) can be tested and debugged by using the positioning block (30).

2. The electronic device according to claim 1, wherein the soldering pad is electrically connected to the circuit on the board body.

3. The electronic device according to any one of claim 1 or 2, wherein there are a plurality of the first pins, the plurality of the first pins are arranged at intervals in a preset direction, and the plurality of the positioning blocks are distributed at two ends of the first pins in the preset direction.

4. The electronic device according to any one of claim 1 to 3, wherein the positioning block is column shaped, and a bottom end of the positioning block is connected to the board body.

5. The electronic device according to claim 1, wherein the board body includes at least one first substrate and a circuit that is made of a conductive material and disposed on the first substrate.

6. The electronic device according to claim 5, wherein the circuit board is a single-layer board, the board body is provided with a first substrate, and a side surface of the first substrate is formed with a circuit having a specific pattern, where one side surface of the first substrate is formed with the circuit or two side surfaces of the first substrate are each formed with the circuit.

7. The electronic device according to claim 5, wherein the circuit board is a multi-layer board, correspondingly, the board body includes a plurality of the first substrates, the plurality of the first substrates are stacked, and a side surface of each first substrate is provided with a circuit having a specific pattern.

8. The electronic device according to claim 6 or 7, wherein the specific pattern on the first substrate is formed by etching.

9. The electronic device according to claim 8, wherein the specific pattern on the first substrate is formed by etching according to the following process:
a metal layer is formed on the first substrate through electroplating, a protective layer is formed on the metal layer, and a mask is covered on the protective layer, where the mask is provided with a light shading part having the same shape as the pattern of the circuit; and the mask is exposed, and the protective layer outside the light shading part undergoes a physical or chemical change due to illumination, and the exposed protective layer and the metal layer corresponding to the exposed protective layer are etched by using an etching solution.

10. The electronic device according to any one of claims 1 to 9, wherein the flexible board is attached to the board body, and the positioning block is penetrated into the positioning hole.

## Patentansprüche

1. Elektronische Vorrichtung, umfassend eine flexible Platte (20) und eine Leiterplatte (10), wobei die flexible Platte (20) mit einem Positionierungsloch (201) und einem zweiten Stift (202) versehen ist, der mit einer Schaltung auf der flexiblen Platte (20) elektrisch verbunden ist, die Leiterplatte (10) umfassend einen Plattenkörper und einen Positionierungsblock (30), der auf dem Plattenkörper angeordnet ist,
wobei der Positionierungsblock ein Metallblock ist; der Positionierungsblock mit einer Schaltung auf dem Plattenkörper elektrisch verbunden ist; wobei ein Lötpad auf einer Oberfläche des Plattenkörpers angeordnet ist und der Positionierungsblock an das Lötpad gelötet ist, wobei es eine Vielzahl der Positionierungsblöcke gibt und die Vielzahl der Positionierungsblöcke in Abständen angeordnet ist, wobei ein erster Stift (101) auf dem Plattenkörper angeordnet ist, der erste Stift mit der Schaltung auf dem Plattenkörper elektrisch verbunden ist, und der erste Stift konfiguriert ist, um mit einem zweiten Stift (202) auf der flexiblen Platte elektrisch verbunden zu werden, um die Schaltung auf der Leiterplatte (10) mit der Schaltung auf der flexiblen Platte (20) zu verbinden, und die Vielzahl der Positionierungsblöcke auf einer Umfangsseite des ersten Stifts verteilt ist; und
das Positionierungsloch (201) ein kreisförmiges Loch ist, der Positionierungsblock (30) zylindrisch ist, wobei der Positionierungsblock (30) in das Positionierungsloch (201) eingedrungen ist und die Distanz zwischen dem Positionierungsblock (30) und dem Positionierungsloch (201) 0,05 mm bis 0,1 mm beträgt und der Positionierungsblock (30) eine externe Schnittstelle ausbildet, sodass die Leiterplatte (10) durch Verwenden des Positionierungsblocks (30) geprüft und ausgetestet werden kann.

2. Elektronische Vorrichtung nach Anspruch 1, wobei das Lötpad mit der Schaltung auf dem Plattenkörper elektrisch verbunden ist.

3. Elektronische Vorrichtung nach einem der Ansprüche 1 oder 2, wobei es eine Vielzahl der ersten Stifte gibt, die Vielzahl der ersten Stifte in Abständen in einer voreingestellten Richtung angeordnet sind, und die Vielzahl der Positionierungsblöcke an zwei Enden der ersten Stifte in der voreingestellten Richtung verteilt ist.

4. Elektronische Vorrichtung nach einem der Ansprüche 1 bis 3, wobei der Positionierungsblock säulenförmig ist und ein unteres Ende des Positionierungsblocks mit dem Plattenkörper verbunden ist.

5. Elektronische Vorrichtung nach Anspruch 1, wobei der Plattenkörper mindestens ein erstes Substrat und eine Schaltung einschließt, die aus einem leitfähigen Material hergestellt und auf dem ersten Substrat angeordnet ist.

6. Elektronische Vorrichtung nach Anspruch 5, wobei die Leiterplatte eine einschichtige Platte ist, der Plattenkörper mit einem ersten Substrat versehen ist, und eine Seitenoberfläche des ersten Substrats mit einer Schaltung ausgebildet ist, die ein spezifisches Muster aufweist, wobei eine Seitenoberfläche des ersten Substrats mit der Schaltung ausgebildet ist oder zwei Seitenoberflächen des ersten Substrats jeweils mit der Schaltung ausgebildet sind.

7. Elektronische Vorrichtung nach Anspruch 5, wobei die Leiterplatte eine mehrschichtige Platte ist, dementsprechend der Plattenkörper eine Vielzahl der ersten Substrate einschließt, die Vielzahl der ersten Substrate gestapelt ist und eine Seitenoberfläche jedes ersten Substrats mit einer Schaltung versehen ist, die ein spezifisches Muster aufweist.

8. Elektronische Vorrichtung nach Anspruch 6 oder 7, wobei das spezifische Muster auf dem ersten Substrat durch Ätzen ausgebildet wird.

9. Elektronische Vorrichtung nach Anspruch 8, wobei das spezifische Muster auf dem ersten Substrat durch Ätzen gemäß dem folgenden Prozess ausgebildet wird:
eine Metallschicht wird auf dem ersten Substrat durch Galvanisieren ausgebildet, eine Schutzschicht wird auf der Metallschicht ausgebildet, und eine Maske wird auf der Schutzschicht bedeckt, wobei die Maske mit einem Lichtabschattungsteil versehen ist, das die gleiche Form wie das Muster der Schaltung aufweist; und die Maske liegt frei und die Schutzschicht erfährt außerhalb des Lichtabschattungsteils eine physikalische oder chemische Änderung aufgrund von Beleuchtung, und die freiliegende Schutzschicht und die Metallschicht, die der freiliegenden Schutzschicht entspricht, werden unter Verwendung einer Ätzlösung geätzt.

10. Elektronische Vorrichtung nach einem der Ansprüche 1 bis 9, wobei die flexible Platte an dem Plattenkörper befestigt ist und der Positionierungsblock in das Positionierungsloch eingedrungen ist.

## Revendications

1. Dispositif électronique, comprenant une carte flexible (20) et une carte de circuit (10), dans lequel la carte flexible (20) est pourvue d'un trou de positionnement (201) et d'une seconde broche (202) connectée électriquement à un circuit sur la carte flexible (20), la carte de circuit (10) comprenant un corps de carte et un bloc de positionnement (30) disposé sur le corps de carte,
dans lequel le bloc de positionnement est un bloc métallique ; le bloc de positionnement est connecté électriquement à un circuit sur le corps de carte ; dans lequel un plot de soudure est disposé sur une surface du corps de carte, et le bloc de positionnement est soudé au plot de soudure, dans lequel il y a une pluralité des blocs de positionnement, et la pluralité des blocs de positionnement sont agencés à des intervalles, dans lequel une première broche (101) est disposée sur le corps de carte, la première broche est connectée électriquement au circuit sur le corps de carte, et la première broche est configurée pour être connectée électriquement à une seconde broche (202) sur la carte flexible pour connecter le circuit sur la carte de circuit (10) au circuit sur la carte flexible (20), et la pluralité des blocs de positionnement sont répartis sur un côté circonférentiel de la première broche ; et
le trou de positionnement (201) est un trou circulaire, le bloc de positionnement (30) est cylindrique, dans lequel on fait pénétrer le bloc de positionnement (30) dans le trou de positionnement (201) et la distance entre le bloc de positionnement (30) et le trou de positionnement (201) va de 0,05 mm à 0,1 mm et le bloc de positionnement (30) forme une interface externe, de sorte que la carte de circuit (10) peut être testée et déboguée en utilisant le bloc de positionnement (30).

2. Dispositif électronique selon la revendication 1, dans lequel le plot de soudure est connecté électriquement au circuit sur le corps de carte.

3. Dispositif électronique selon l'une quelconque de la revendication 1 ou 2, dans lequel il y a une pluralité des premières broches, la pluralité des premières broches sont agencées à des intervalles dans une direction prédéfinie, et la pluralité des blocs de positionnement sont répartis au niveau de deux extrémités des premières broches dans la direction prédéfinie.

4. Dispositif électronique selon l'une quelconque de la revendication 1 à 3, dans lequel le bloc de positionnement est en forme de colonne, et une extrémité inférieure du bloc de positionnement est reliée au corps de carte.

5. Dispositif électronique selon la revendication 1, dans lequel le corps de carte comporte au moins un premier substrat et un circuit qui est constitué d'un matériau conducteur et disposé sur le premier substrat.

6. Dispositif électronique selon la revendication 5, dans lequel la carte de circuit est une carte à couche unique, le corps de carte est pourvu d'un premier substrat, et une surface latérale du premier substrat est formée avec un circuit ayant un motif spécifique, où une surface latérale du premier substrat est formée avec le circuit ou deux surfaces latérales du premier substrat sont chacune formées avec le circuit.

7. Dispositif électronique selon la revendication 5, dans lequel la carte de circuit est une carte à couches multiples, de manière correspondante, le corps de carte comporte une pluralité des premiers substrats, la pluralité des premiers substrats sont empilés, et une surface latérale de chaque premier substrat est pourvue d'un circuit ayant un motif spécifique.

8. Dispositif électronique selon la revendication 6 ou 7, dans lequel le motif spécifique sur le premier substrat est formé par décapage.

9. Dispositif électronique selon la revendication 8, dans lequel le motif spécifique sur le premier substrat est formé par décapage selon le procédé suivant :
une couche métallique est formée sur le premier substrat par dépôt électrolytique, une couche protectrice est formée sur la couche métallique, et un masque est couvert sur la couche protectrice, où le masque est pourvu d'une partie d'ombrage de lumière ayant la même forme que le motif du circuit ; et le masque est exposé, et la couche protectrice à l'extérieur de la partie d'ombrage de lumière subit un changement physique ou chimique en raison de l'illumination, et la couche protectrice et la couche métallique exposées correspondant à la couche protectrice exposée sont décapées en utilisant une solution décapante.

10. Dispositif électronique selon l'une quelconque des revendications 1 à 9, dans lequel la carte flexible est fixée au corps de carte, et l'on fait pénétrer le bloc de positionnement dans le trou de positionnement.
